# EUROPEAN PATENT APPLICATION

(11) **EP 2 653 894 A1**
(43) Date of publication of application: **23.10.2013**
(21) Application number: 12854553.0
(22) Date of filing: 31.12.2012
(51) Int. Cl.: G01V 3/00

(54) **APPROACH DETECTION DEVICE AND MOBILE TERMINAL**

(30) Priority: 03.02.2012 CN 201210023924
(71) Applicant: Huawei Device Co., Ltd., Longgang District Shenzhen Guangdong 518129 (CN)
(72) Inventor: WANG, Aimeng, Shenzhen Guangdong 518129 (CN); FAN, Baomin, Shenzhen Guangdong 518129 (CN); ZOU, Yanyan, Shenzhen Guangdong 518129 (CN); TANG, Wei, Shenzhen Guangdong 518129 (CN)
(74) Representative: Epping - Hermann - Fischer
(86) International application number: PCT/CN2012/087958
(87) International publication number: WO 2013/113246

(57) **Abstract**

Embodiments of the present invention provide a proximity detection device, including: a mobile terminal antenna body and a mobile terminal side metal strip, configured to detect capacitance of a space between the mobile terminal antenna body and the mobile terminal side metal strip; and a capacitance detection sensor circuit, connected to the mobile terminal antenna body and the mobile terminal side metal strip in an electrically coupling manner, and configured to determine whether a person is approaching according to the capacitance detected by the mobile terminal antenna body and the mobile terminal side metal strip, and output an indication signal when it is determined that a person is approaching, so as to indicate that a person is approaching. In the embodiments of the present invention, a mobile terminal antenna body and a mobile terminal side metal strip detect capacitance of a space between the mobile terminal antenna body and the mobile terminal side metal strip, and a capacitance detection sensor circuit determines whether a person is approaching according to the capacitance, thereby implementing a proximity detection solution. Therefore, an internal space of a mobile terminal is saved, a difficulty in designing the mobile terminal is reduced, and a cost is lowered, which is beneficial to making the mobile terminal smaller, lighter and thinner.

## Description

This application claims priority to Chinese Patent Application No. 201210023924.4, filed with the Chinese Patent Office on February 3, 2012 and entitled "PROXIMITY DETECTION DEVICE AND MOBILE TERMINAL", which is incorporated herein by reference in its entirety.

### TECHNICAL FIELD

Embodiments of the present invention relate to the communications field, and in particular, to a proximity detection device and a mobile terminal.

### BACKGROUND

With the development of an electronic technology, wireless products such as mobile terminals (for example, a smart phone, a tablet computer, and a portable personal computer) are becoming essential living and office supplies for people. In order to prevent damages of excessive radiation of wireless products to people, both the United States Federal Communications Commission and the European Union have strict authentication specifications on a SAR (Specific Absorption Rate, specific absorption rate) value of wireless products.

In order to lower a SAR value of a product, currently, a proximity sensor for detecting approaching and leaving of a person is added in some wireless products; and when it is detected that a person is approaching, transmit power is lowered, so as to reduce the radiation of the product on people.

In an existing proximity sensor technical solution, an FPC (Flexible Printed Circuit, flexible printed circuit) that is placed near an antenna is used to detect a change of capacitance. In order to ensure the precision and stability of detection, an area of the FPC is generally required to be about 28 mm * 25 mm. Addition of such a large capacitance detection FPC near an antenna results in a great waste of an internal space of a mobile terminal that is originally limited, which is not beneficial to making the mobile terminal smaller, lighter and thinner.

### SUMMARY

In order to solve the foregoing problem, embodiments of the present invention provide a proximity detection device and a mobile terminal.

In one aspect, an embodiment of the present invention provides a proximity detection device, including: a mobile terminal antenna body and a mobile terminal side metal strip, forming two electrodes of a capacitor, and configured to detect capacitance of a space between the mobile terminal antenna body and the mobile terminal side metal strip; and a capacitance detection sensor circuit, connected to each of the mobile terminal antenna body and the mobile terminal side metal strip in an electrically coupling manner, and configured to determine whether a person is approaching according to the capacitance detected by the mobile terminal antenna body and the mobile terminal side metal strip, and output an indication signal when it is determined that a person is approaching.

In another aspect, an embodiment of the present invention provides a mobile terminal, including a proximity detection device. The proximity detection device includes: a mobile terminal antenna body and a mobile terminal side metal strip, forming two electrodes of a capacitor, and configured to detect capacitance of a space between the mobile terminal antenna body and the mobile terminal side metal strip; and a capacitance detection sensor circuit, connected to each of the mobile terminal antenna body and the mobile terminal side metal strip in an electrically coupling manner, and configured to determine whether a person is approaching according to the capacitance detected by the mobile terminal antenna body and the mobile terminal side metal strip, and output an indication signal when it is determined that a person is approaching.

In the embodiments of the present invention, a mobile terminal antenna body and a mobile terminal side metal strip detect capacitance of a space between the mobile terminal antenna body and the mobile terminal side metal strip, and a capacitance detection sensor circuit determines whether a person is approaching according to the capacitance, thereby implementing proximity detection. Because an antenna body and a side metal strip of a mobile terminal are used, an internal space of the mobile terminal may be saved, a difficulty in designing the mobile terminal may be reduced, and a cost may be lowered, which is beneficial to making the mobile terminal smaller, lighter and thinner.

### BRIEF DESCRIPTION OF DRAWINGS

FIG. 1 is a schematic diagram of a rear structure of a mobile terminal;

FIG. 2 is a schematic structural diagram of a proximity detection device according to an embodiment of the present invention;

FIG. 3 is a schematic structural diagram of another proximity detection device according to an embodiment of the present invention;

FIG. 4 is a schematic structural diagram of another proximity detection device according to an embodiment of the present invention;

FIG. 5 is a schematic diagram of pins of an AD7156 chip;

FIG. 6 is a schematic structural diagram of a circuit of the AD7156 chip;

FIG. 7 is a schematic structural diagram of another proximity detection device according to an embodiment of the present invention;

FIG. 8 is a schematic structural diagram of another proximity detection device according to an embodiment of the present invention;

FIG. 9 is a schematic structural diagram of another proximity detection device according to an embodiment of the present invention; and

FIG. 10 is a schematic structural diagram of a mobile terminal according to an embodiment of the present invention.

### DESCRIPTION OF EMBODIMENTS

The technical solutions in the embodiments of the present invention are clearly described in the following with reference to the accompanying drawings in the embodiments of the present invention. It is obvious that the embodiments to be described are only a part rather than all of the embodiments of the present invention. All other embodiments obtained by persons of ordinary skill in the art based on the embodiments of the present invention without creative efforts shall fall within the protection scope of the present invention. First, terms and terminologies in the following embodiments are explained as follows.

The so-called "mobile terminal" refers to various mobile communication equipments with a size suitable for movement, and includes, but is not limited to, a mobile phone, a tablet computer, a portable personal computer, and so on.

When it is mentioned in the following embodiments that A is "coupled to" B, it means that an electrical signal that passes through A and an electrical signal that passes through B has determined association in physics, which includes that A is directly connected to B through a conducting wire, or is indirectly connected to B through another component C, and also includes that an electrical signal that passes through A and an electrical signal that passes through B are associated through electromagnetic induction, as what a transformer does.

When an ordinal term such as "first" or "second" is mentioned in the embodiments of the present invention, unless it is definite that the ordinal term expresses the meaning of order according to a context, it should be understood that the ordinal term is used only for differentiation.

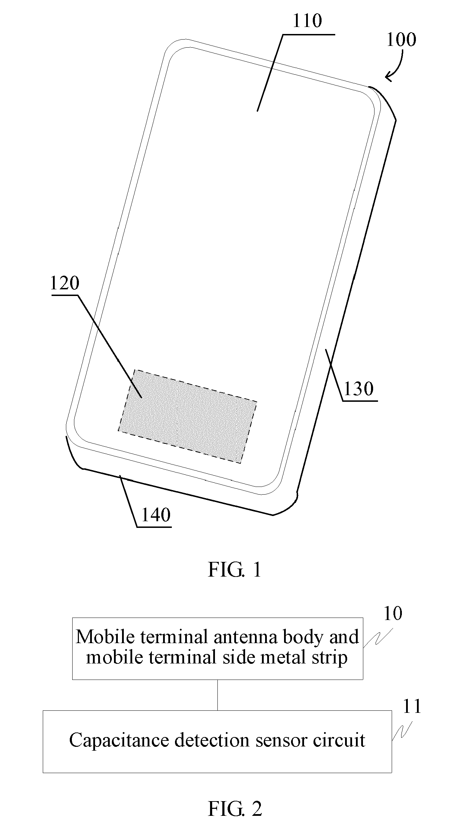

In an existing proximity detection solution, a separate capacitive FPC is used in a mobile terminal to detect capacitance around the mobile terminal and determine whether a person is approaching through a change of the capacitance. FIG. 1 is a schematic diagram of a rear structure of a mobile terminal. The terminal mobile 100 has a cuboid shape, and has six external planes. FIG. 1 shows a rear surface 110 of the mobile terminal, a left side surface 130 of the terminal surface, and a lower side surface 140 of the mobile terminal. An antenna area 120 is a projection area of an antenna body of the mobile terminal 100 on the rear surface 110 of the mobile terminal. Because strict specifications are made on SAR values of planes of a mobile terminal, a capacitive FPC needs to be arranged on each plane of a mobile terminal, especially a plane where an antenna is located. An area of the FPC is generally about 28 mm * 25 mm, and an FPC area of an antenna transmit plane needs to be larger than an area of an antenna, so as to cover the antenna transmit plane. With a trend of making a mobile terminal smaller, lighter and thinner, an internal space of the mobile terminal is originally limited, and definitely, the addition of an FPC with such a large area inside the mobile terminal greatly increases the internal space of the mobile terminal, thereby increasing a difficulty in designing the mobile terminal.

In a process of implementing the present invention, the inventor finds that capacitance formed by an antenna body and a side metal strip of a mobile terminal may meet a requirement of a front-end detection capacitance range of a capacitance detection chip, and when a person is approaching, a variation of capacitance caused by a change of a dielectric constant around the front-end detection capacitance may meet a design requirement. In this way, a variation of capacitance of a capacitor formed by the antenna body and the side metal strip may be used for detecting an approaching distance of a person. FIG. 2 is a schematic structural diagram of a proximity detection device according to an embodiment of the present invention. The device includes a mobile terminal antenna body and a mobile terminal side metal strip 10, forming two electrodes of a capacitor, and configured to detect capacitance of a space between the mobile terminal antenna body and the mobile terminal side metal strip.

The proximity detection device further includes a capacitance detection sensor circuit 11. The capacitance detection sensor circuit 11 is connected to the mobile terminal antenna body and the mobile terminal side metal strip 10 in an electrically coupling manner, and is configured to determine whether a person is approaching according to the capacitance detected by the mobile terminal antenna body and the mobile terminal side metal strip, and output an indication signal when it is determined that a person is approaching, where the indication signal is used for indicating that a person is approaching. Specifically, when a person is approaching the proximity detection device, a dielectric constant around the mobile terminal antenna body and the mobile terminal side metal strip 10 changes, so that the capacitance detected by the mobile terminal antenna body and the mobile terminal side metal strip 10 changes. The capacitance detection sensor circuit 11 determines whether a person is approaching according to a change of the capacitance, and outputs an indication signal indicating that a person is approaching, such as a high level or a low level, when it is determined that a person is approaching.

In this embodiment of the present invention, a mobile terminal antenna body and a mobile terminal side metal strip detect capacitance of a space between the mobile terminal antenna body and the mobile terminal side metal strip, and a capacitance detection sensor circuit determines whether a person is approaching according to the capacitance, thereby implementing a proximity detection solution. Therefore, an internal space of a mobile terminal is saved, a difficulty in designing the mobile terminal is reduced, and a cost is lowered, which is beneficial to making the mobile terminal smaller, lighter and thinner.

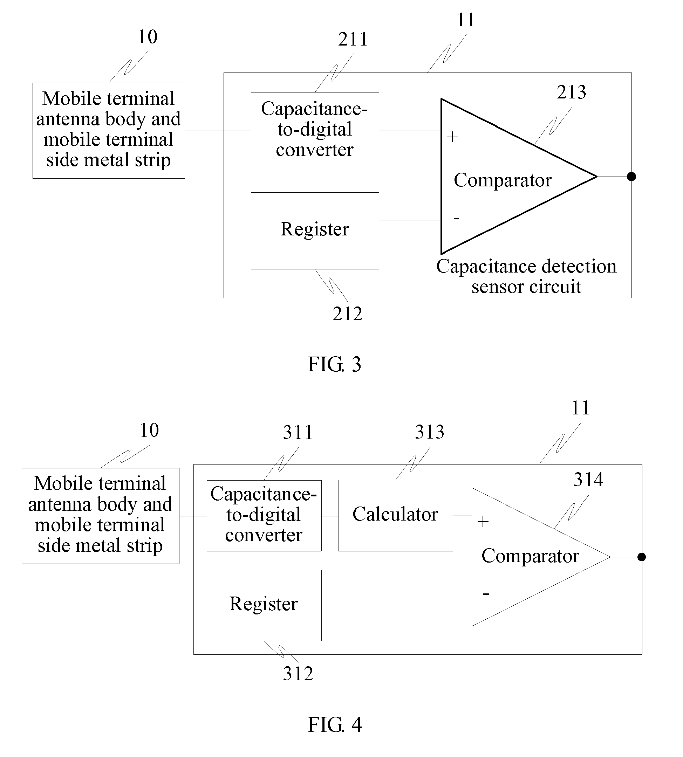

FIG. 3 is a schematic structural diagram of a proximity detection device according to an embodiment of the present invention. The proximity detection device includes a mobile terminal antenna body and a mobile terminal side metal strip 10 and a capacitance detection sensor circuit 11, where the capacitance detection sensor circuit 11 includes a capacitance-to-digital converter 211, a register 212, and a comparator 213.

The mobile terminal antenna body and the mobile terminal side metal strip 10 are configured to detect capacitance of a space between the mobile terminal antenna body and the mobile terminal side metal strip 10. The mobile terminal antenna body and the mobile terminal side metal strip in the mobile terminal antenna body and the mobile terminal side metal strip 10 are equivalent to two capacitance electrodes of one capacitor, and may detect the capacitance of the space between the mobile terminal antenna body and the mobile terminal side metal strip 10 in real time. When an environment around the mobile terminal antenna body and the mobile terminal side metal strip 10 changes, for example, when a person is approaching or another object is approaching, a dielectric constant around the mobile terminal antenna body and the mobile terminal side metal strip 10 changes, and further, the capacitance detected by the mobile terminal antenna body and the mobile terminal side metal strip 10 changes.

The capacitance-to-digital converter 211 is configured to obtain the capacitance detected by the mobile terminal antenna body and the mobile terminal side metal strip 10, and convert the capacitance into a first capacitance value. Because the capacitance detected by the mobile terminal antenna body and the mobile terminal side metal strip 10 is an analog signal, the capacitance needs to be converted into a digital signal herein, that is, the first capacitance value, so as to facilitate subsequent processing.

The register 212 stores a second capacitance threshold, where the second capacitance threshold is a corresponding capacitance value when a person is approaching. The second capacitance threshold may be determined according to an actual need of product design, for example, during product designing, if it is determined that when a distance between a person and the device is less than 13 mm, it is considered that a person is approaching the device, a capacitance value corresponding to the capacitance detected by the mobile terminal antenna body and the mobile terminal side metal strip when the distance between the person and the device is 13 mm may be set as the second capacitance threshold, and the second capacitance threshold is used as a critical point of a capacitance value for determining whether a person is approaching the device.

The comparator 213 is configured to determine whether a person is approaching according to the first capacitance value and the second capacitance threshold, and output an indication signal when it is determined that a person is approaching, where the indication signal is used for indicating that a person is approaching.

Based on a capacitance conversion manner of the capacitance-to-digital converter 211, when a person is approaching, the first capacitance value may become larger or may become smaller. According to the capacitance conversion manner of the capacitance-to-digital converter 211, the comparator 213 may adopt different comparison modes.

Specifically, when a person is approaching, if the first capacitance value becomes larger, the first capacitance value is compared with the second capacitance threshold to determine whether the first capacitance value is larger than the second capacitance threshold, and when the first capacitance value is larger than the second capacitance threshold, an indication signal is output, where the indication signal is used for indicating that a person is approaching; or, when a person is approaching, if the first capacitance value becomes smaller, the first capacitance value is compared with the second capacitance threshold to determine whether the first capacitance value is smaller than the second capacitance threshold, when the first capacitance value is smaller than the second capacitance threshold, an indication signal output, where the indication signal is used for indicating that a person is approaching.

Further, the indication signal may be a high level, or may also be a low level. Specifically, the comparator 213 outputs a low level when no person is approaching, and when a person is approaching, outputs a high level to indicate that a person is approaching; or, the comparator outputs a high level when no person is approaching, and when a person is approaching, outputs a low level to indicate that a person is approaching.

In this embodiment of the present invention, a mobile terminal antenna body and a mobile terminal side metal strip detect capacitance of a space between the mobile terminal antenna body and the mobile terminal side metal strip, and a capacitance detection sensor circuit determines whether a person is approaching according to the capacitance, thereby implementing a proximity detection solution. Therefore, an internal space of a mobile terminal is saved, a difficulty in designing the mobile terminal is reduced, and a cost is lowered, which is beneficial to making the mobile terminal smaller, lighter and thinner.

FIG. 4 is a schematic structural diagram of another proximity detection device according to an embodiment of the present invention. The proximity detection device includes a mobile terminal antenna body and a mobile terminal side metal strip 10 and a capacitance detection sensor circuit 11, where the capacitance detection sensor circuit 11 includes a capacitance-to-digital converter 311, a register 312, a calculator 313, and a comparator 314.

The mobile terminal antenna body and the mobile terminal side metal strip 10 are configured to detect capacitance of a space between the mobile terminal antenna body and the mobile terminal side metal strip 10. The mobile terminal antenna body and the mobile terminal side metal strip in the mobile terminal antenna body and the mobile terminal side metal strip 10 are equivalent to two capacitance electrodes of one capacitor, and may detect the capacitance of the space between the mobile terminal antenna body and the mobile terminal side metal strip 10 in real time. When an environment around the mobile terminal antenna body and the mobile terminal side metal strip 10 changes, for example, when a person is approaching or another object is approaching, a dielectric constant around the mobile terminal antenna body and the mobile terminal side metal strip 10 changes, and further, the capacitance detected by the mobile terminal antenna body and the mobile terminal side metal strip 10 changes.

The capacitance-to-digital converter 311 is configured to obtain the capacitance detected by the mobile terminal antenna body and the mobile terminal side metal strip 10, and convert the capacitance into a first capacitance value. Because the capacitance detected by the mobile terminal antenna body and the mobile terminal side metal strip 10 is an analog signal, the capacitance needs to be converted into a digital signal herein, that is, the first capacitance value, so as to facilitate subsequent processing.

The register 312 stores a third capacitance value and a fourth capacitance difference. The third capacitance value is a capacitance value when no person is approaching, and the fourth capacitance difference is a difference between a capacitance value when a person is approaching and the third capacitance value.

The fourth capacitance difference may be determined according to an actual need of product design, for example, during product designing, if it is determined that when a distance between a person and the device is less than 13 mm, it is considered that a person is approaching the device, a difference between a capacitance value corresponding to the capacitance detected by the mobile terminal antenna body and the third capacitance value when the distance between the person and the device is 13 mm may be used as a critical point of a capacitance value for determining whether a person is approaching the device.

The calculator 313 is configured to calculate a fifth capacitance difference between the first capacitance value and the third capacitance value.

The comparator 314 is configured to compare the fifth capacitance difference with the fourth capacitance difference to determine whether the fifth capacitance difference is larger than the fourth capacitance difference, and when the fifth capacitance difference is larger than the fourth capacitance difference, output an indication signal, where the indication signal is used for indicating that a person is approaching.

Further, the indication signal may be a high level, or may also be a low level. Specifically, the comparator 314 outputs a low level when no person is approaching, and when a person is approaching, outputs a high level to indicate that a person is approaching; or, the comparator 314 outputs a high level when no person is approaching, and when a person is approaching, outputs a low level to indicate that a person is approaching.

In this embodiment of the present invention, a mobile terminal antenna body and a mobile terminal side metal strip detect capacitance of a space between the mobile terminal antenna body and the mobile terminal side metal strip, and a capacitance detection sensor circuit determines whether a person is approaching according to the capacitance, thereby implementing a proximity detection solution. Therefore, an internal space of a mobile terminal is saved, a difficulty in designing the mobile terminal is reduced, and a cost is lowered, which is beneficial to making the mobile terminal smaller, lighter and thinner.

The capacitance detection sensor circuit may be a capacitance converter. The capacitance converter is a capacitance proximity detection sensor chip, which can determine whether a person is approaching according to an output capacitance signal and output an indication signal indicating that a person is approaching.

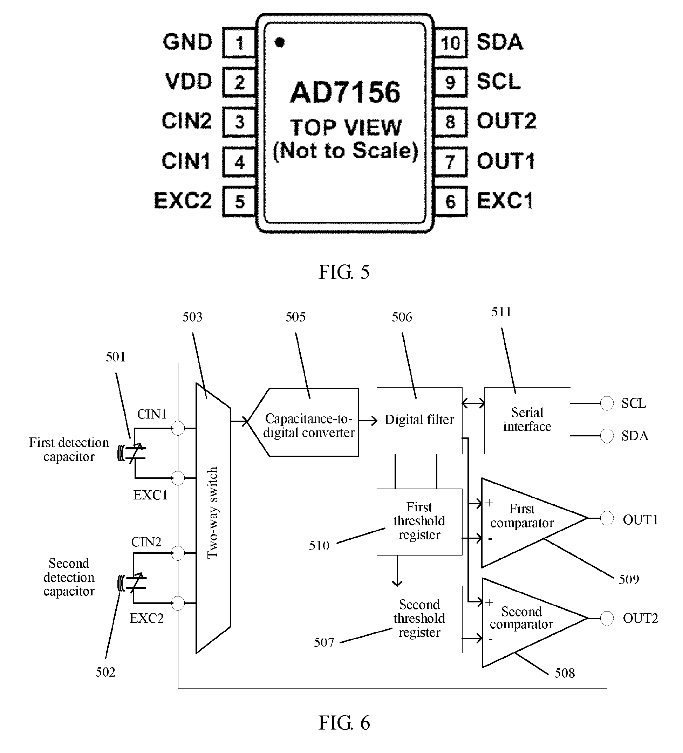

FIG. 5 is a schematic diagram of pins of an AD7156. The AD7156 is a dual-path capacitance converter (Capacitance Converter) manufactured by ADI (Analog Devices, Analog Devices Inc.). As shown in the figure, the AD7156 has ten pins. Specifically, names and functions of the pins are described as follows.

| Pin number | Pin name | Function |
|---|---|---|
| 1 | GND | Ground |
| 2 | VDD | Supply voltage |
| 3 | CIN2 | Capacitance input path 2 |
| 4 | CIN1 | Capacitance input path 1 |
| 5 | EXC2 | Excitation signal path 2 |
| 6 | EXC1 | Excitation signal path 1 |
| 7 | OUT1 | Logic output path 1 |
| 8 | OUT2 | Logic output path 2 |
| 9 | SCL | Input clock signal |
| 10 | SDA | Input bidirectional data signal |

In practice, merely one path may be used, and two paths may also be used simultaneously. For example, the CIN1 of the AD7156 is connected to a mobile terminal antenna body in an electrically coupling manner; and the EXC1 is connected to a mobile terminal side metal strip in an electrically coupling manner. The AD7156 determines whether a person is approaching according to input capacitance, and outputs a high-level signal from the OUT1 when it is determined that a person is approaching. The CIN1 and the EXC2 of the AD7156 each may also be connected to two electrodes of another FPC capacitor to form another path.

FIG. 6 is a schematic structural diagram of a circuit of an AD7156 according to an embodiment of the present invention. The circuit includes two paths, namely, a first capacitance path where a first detection capacitor 501 is located, where two capacitance electrodes of the first detection capacitor 501 are connected to CIN1 and EXC1 of the AD7156 respectively to form the first capacitance path; and a second capacitance path where a second detection capacitor 502 is located, where two capacitance electrodes of the second detection capacitor 502 are connected to CIN2 and EXC2 of the AD7156 respectively to form the second capacitance path. Selection of the two paths is implemented through a two-way switch 503. When the two-way switch 503 is connected to the first capacitance path, the AD7156 obtains capacitance detected by the first detection capacitor 501; and when the two-way switch 503 is connected to the second capacitance path, the AD7156 obtains capacitance detected by the second detection capacitor 502.

A logical structure of the AD7156 and functions of modules are described by taking a process that the AD7156 processes a capacitance signal detected by the first detection capacitor 501 as an example. As shown in FIG. 6, when the two-way switch 503 selects the first capacitance path, the capacitance signal detected by the first detection capacitor 501 is input into the AD7156 through the CIN1 and the EXC1; the capacitance signal is an analog signal and is converted into a digital signal, that is, a first capacitance value, through a capacitance-to-digital converter 505; due to influence of an environment, the capacitance detected by the first detection capacitor 501 may vary within a small range or have noises, and therefore the first capacitance value is not stable and fluctuates within a small range, and needs to undergo filtering processing of a digital filter 506, such as averaging, to obtain a relatively stable first capacitance value; the first capacitance value is input into a first comparator 509, and simultaneously, a second capacitance threshold stored in a first threshold register 510 is also input into the first comparator 509, where the second capacitance threshold is a capacitance value corresponding to the capacitance detected by the first detection capacitor 501 when a person is approaching; and the first comparator 509 compares the first capacitance value with the second capacitance threshold to determine whether the first capacitance value is larger than the second capacitance threshold, and when the first capacitance value is larger than the second capacitance threshold, outputs a high level to indicate that a person is approaching. The high level is output through OUT 1.

Optionally, based on a conversion manner of the capacitance-to-digital converter 505, when a person is approaching, the first capacitance value may also become smaller; and in this case, the first comparator 509 compares the first capacitance value with the second capacitance threshold to determine whether the first capacitance value is smaller than the second capacitance threshold, and when the first capacitance value is smaller than the second capacitance threshold, the first comparator outputs a high level to indicate that a person is approaching. The high level is output through the OUT 1.

The AD7156 further includes a second threshold register 507 and a second comparator 508. The second threshold register 507 stores a third capacitance threshold, where the third capacitance threshold is a capacitance value corresponding to the capacitance detected by the second detection capacitor 502 when a person is approaching. A working principle of the second comparator 508 is the same as that of the first comparator 509. When the AD7156 selects the second capacitance path, the second comparator 508 compares the capacitance value corresponding to the capacitance detected by the second detection capacitor 502 with the third capacitance threshold to determine whether the capacitance value corresponding to the capacitance detected by the second detection capacitor 502 is larger than the third capacitance threshold, and when the capacitance value corresponding to the capacitance detected by the second detection capacitor 502 is larger than the third capacitance threshold, the second comparator 508 outputs a high level to indicate that a person is approaching. The high level is output through OUT2.

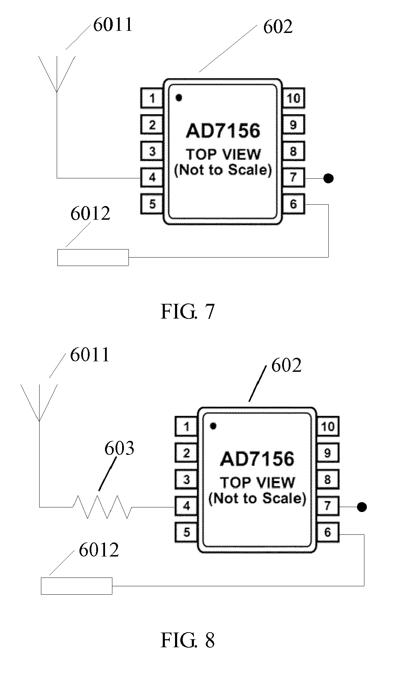

FIG. 7 is a schematic structural diagram of another proximity detection device according to an embodiment of the present invention. The proximity detection device includes a mobile terminal antenna body 6011, a mobile terminal side metal strip 6012, and an AD7156 chip 602. The mobile terminal antenna body 6011 is connected to a fourth pin, that is, CIN1, of the AD7156 chip 602; the mobile terminal side metal strip 6012 is connected to a sixth pin, that is, EXC1, of the AD7156 chip 602; the mobile terminal antenna body 6011 and the mobile terminal side metal strip 6012 form two capacitance electrodes of a capacitor. Capacitance of a space between a capacitor formed by the mobile terminal antenna body 6011 and the mobile terminal side metal strip 6012 is detected. A detected capacitance signal is output into the AD7156 chip 602. For a method for the AD7156 chip to determine whether a person is approaching, reference may be made to the description about the embodiment shown in FIG. 5. An indication signal indicating that a person is approaching is output.

In this embodiment of the present invention, a mobile terminal antenna body and a mobile terminal side metal strip detect capacitance of a space between the mobile terminal antenna body and the mobile terminal side metal strip, and a capacitance detection sensor circuit determines whether a person is approaching according to the capacitance, thereby implementing a proximity detection solution. Therefore, an internal space of the mobile terminal is saved, a difficulty in designing the mobile terminal is reduced, and a cost is lowered, which is beneficial to making the mobile terminal smaller, lighter and thinner.

Further, as shown in FIG. 8, in order to reduce the influence of a metal strip or wiring around the mobile terminal antenna body on antenna performance, a high-frequency inductor 603 may be connected in series between the mobile terminal antenna body 6011 and the AD7156 chip 602, and an inductance value of the high-frequency inductor 603 may be 82 nH or 68 nH. Definitely, if the AD7156 chip is replaced by another capacitance detection sensor circuit, a high-frequency inductor may also be connected between the mobile terminal antenna body and the capacitance detection sensor circuit.

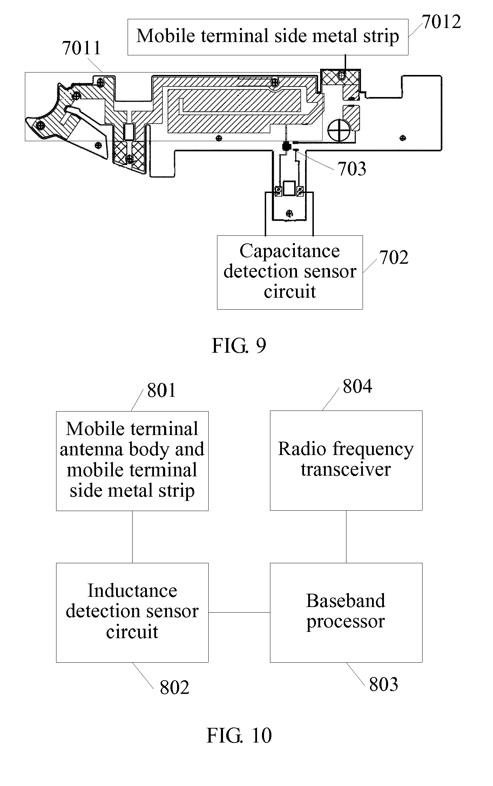

FIG. 9 is a schematic structural diagram of another proximity detection device according to an embodiment of the present invention. The proximity detection device includes a mobile terminal antenna body 7011, a mobile terminal side metal strip 7012, and a capacitance detection sensor circuit 702. The mobile terminal antenna body 7011 and the mobile terminal side metal strip 7012 each are connected to the capacitance detection sensor circuit 702; the mobile terminal antenna body 7011 and the mobile terminal side metal strip 7012 form two capacitance electrodes of a capacitor, and are configured to detect capacitance of a space between a capacitor formed by the mobile terminal antenna body 7011 and the mobile terminal side metal strip 7012, and output a detected capacitance signal into the capacitance detection sensor circuit 702. The capacitance detection sensor circuit 702 determines whether a person is approaching according to the capacitance signal, and output an indication signal indicating that a person is approaching. For a method for the capacitance detection sensor circuit 702 to determine whether a person is approaching according to the capacitance signal, reference may be made to the description about the foregoing embodiment. Further, in order to reduce the influence of a metal strip or wiring around the mobile terminal antenna body 7011 on antenna performance, a high-frequency inductor 703 may be connected in series between the mobile terminal antenna body 7011 and the capacitance detection sensor circuit 702, and an inductance value of the high-frequency inductor 703 may be 82 nH or 68 nH.

Further, the proximity detection device is applicable to various mobile terminals, including, but not limited to, a smart phone, a tablet computer, a portable personal computer, and so on. When the proximity detection device detects that a person is approaching, the mobile terminal adjusts transmit power of a wireless signal to meet a specification of a SAR value, so as to reduce radiation on people. FIG. 10 is a schematic structural diagram of a mobile terminal. The mobile terminal includes a mobile terminal antenna body and a mobile terminal side metal strip 801, an inductance detection sensor circuit 802, a baseband processor 803, and a radio frequency transceiver 804. The mobile terminal antenna body and the mobile terminal side metal strip 801 detect capacitance of a space between the mobile terminal antenna body and the mobile terminal side metal strip 801. The capacitance detection sensor circuit 802 obtains the capacitance detected by the mobile terminal antenna body and the mobile terminal side metal strip 801, determines whether a person is approaching according to the capacitance, and outputs an indication signal, where the indication signal is used for indicating whether a person is approaching. The baseband processor 803 obtains the indication signal, and when the output indication signal indicates that a person is approaching, the baseband processor 803 adjusts maximum transmit power of the radio frequency transceiver 804. For a method for the capacitance detection sensor circuit 802 to determine whether a person is approaching according to the capacitance detected by the mobile terminal antenna body and the mobile terminal side metal strip 801, reference may be made to the description about the foregoing embodiment.

In this embodiment of the present invention, a mobile terminal antenna body detects capacitance of a space of the mobile terminal antenna, and a capacitance detection sensor circuit determines whether a person is approaching according to the capacitance, thereby implementing a proximity detection solution in a mobile terminal; and when it is determined that a person is approaching, maximum transmit power of the mobile terminal is reduced. Therefore, an internal space of the mobile terminal is saved, a difficulty in designing the mobile terminal is reduced, and a cost is lowered, which is beneficial to making the mobile terminal smaller, lighter and thinner. Meanwhile, a SAR value is also lowered, so that the influence of wireless radiation of the mobile terminal on people is reduced.

The modules and devices separately described in the foregoing embodiments and technical features separately described in the embodiments may be combined to form other modules, devices and technologies without departing from the spirit and principle of the present invention, and the modules, devices and technologies formed according to the descriptions of the embodiments of the present invention shall all fall within the protection scope of the present invention.

Definitely, it should be understood by persons of ordinary skill in the art that units or steps in the foregoing embodiments of the present invention may be implemented by a general computing device, and the units or steps may be concentrated on a single computing device or distributed on a network formed by multiple computing devices; and optionally, the units or steps may be implemented by program codes that are executable by a computing device, so that the units or steps may be stored in a storage device and executed by the computing device. Or, the units or steps may be made into circuit modules or implemented by making multiple units or steps of the units or steps into a single circuit module. In this way, the present invention is not limited to a combination of any specific hardware and software.

The foregoing descriptions are merely exemplary embodiments of the present invention, but are not intended to limit the protection scope of the present invention. Any variation or replacement that may be easily figured out by persons skilled in the art within the technical scope disclosed in the present invention should all fall within the protection scope of the present invention. Therefore, the protection scope of the present invention shall be subject to the protection scope of the claims.

## Claims

1. A proximity detection device, comprising:
a mobile terminal antenna body and a mobile terminal side metal strip, forming two electrodes of a capacitor, and configured to detect capacitance of a space between the mobile terminal antenna body and the mobile terminal side metal strip; and
a capacitance detection sensor circuit, connected to each of the mobile terminal antenna body and the mobile terminal side metal strip in an electrically coupling manner, and configured to determine whether a person is approaching according to the capacitance detected by the mobile terminal antenna body and the mobile terminal side metal strip, and output an indication signal when it is determined that a person is approaching.

2. The device according to claim 1, wherein the capacitance detection sensor circuit comprises a capacitance-to-digital converter, a register, and a comparator, wherein
the capacitance-to-digital converter is configured to convert the capacitance detected by the mobile terminal antenna body and the mobile terminal side metal strip into a first capacitance value;
the register is configured to store a second capacitance threshold, wherein the second capacitance threshold is a corresponding capacitance value when a person is approaching; and
the comparator is configured to determine whether a person is approaching according to the first capacitance value and the second capacitance threshold, and output an indication signal when it is determined that a person is approaching, wherein the indication signal is used for indicating that a person is approaching.

3. The device according to claim 2, wherein the comparator is specifically configured to:
when a person is approaching, if the first capacitance value becomes larger, compare the first capacitance value with the second capacitance threshold to determine whether the first capacitance value is larger than the second capacitance threshold, and when the first capacitance value is larger than the second capacitance threshold, output an indication signal, wherein the indication signal is used for indicating that a person is approaching; or
when a person is approaching, if the first capacitance value becomes smaller, compare the first capacitance value with the second capacitance threshold to determine whether the first capacitance value is smaller than the second capacitance threshold, and when the first capacitance value is smaller than the second capacitance threshold, output an indication signal, wherein the indication signal is used for indicating that a person is approaching.

4. The device according to claim 1, wherein the capacitance detection sensor circuit comprises a capacitance-to-digital converter, a register, a calculator, and a comparator, wherein
the capacitance-to-digital converter is configured to convert the capacitance detected by the mobile terminal antenna body and the mobile terminal side metal strip into a first capacitance value;
the register is configured to store a third capacitance value and a fourth capacitance difference, wherein the third capacitance value is a corresponding capacitance value when no person is approaching, and the fourth capacitance difference is a difference between a capacitance value when a person is approaching and the third capacitance value;
the calculator is configured to calculate a fifth capacitance difference between the first capacitance value and the third capacitance value; and
the comparator is configured to compare the fifth capacitance difference with the fourth capacitance difference to determine whether the fifth capacitance difference is larger than the fourth capacitance difference, and when the fifth capacitance difference is larger than the fourth capacitance difference, output an indication signal, wherein the indication signal is used for indicating that a person is approaching.

5. The device according to any one of claims 1 to 4, wherein the indication signal is a high level or a low level.

6. The device according to claim 1, wherein the capacitance detection sensor circuit is a capacitance converter.

7. The device according to any one of claims 1 to 6, further comprising a high-frequency inductor, wherein the high-frequency inductor is connected in series between the mobile terminal antenna body and the capacitance detection sensor circuit.

8. The device according to claim 7, wherein an inductance value of the high-frequency inductor is 82 nH or 68 nH.

9. A mobile terminal, comprising the proximity detection device according to any one of claims 1 to 8.

10. The mobile terminal according to claim 9, further comprising a baseband processing chip and a radio frequency transceiver, wherein
the baseband processing chip is configured to receive an indication signal output by the proximity detection device, and lower maximum transmit power of the radio frequency transceiver according to the indication signal.
